# EUROPÄISCHE PATENTSCHRIFT

(11) **EP 2 220 510 B1**
(45) Veröffentlichungstag und Bekanntmachung des Hinweises auf die Patenterteilung: **18.04.2012**
(21) Anmeldenummer: 08856551.0
(22) Anmeldetag: 24.10.2008
(51) Int. Cl.: G01R 33/00, G01P 1/02, G01P 3/481, G01P 3/487, G01D 11/24, G01R 1/04

(54) **VERFAHREN ZUR HERSTELLUNG EINES MAGNETFELDSENSORS UND NACH DEM VERFAHREN HERGESTELLTER SENSOR**
METHOD FOR PRODUCING A MAGNETIC FIELD SENSOR AND SENSOR PRODUCED ACCORDING TO SAID METHOD
PROCÉDÉ DE FABRICATION D'UN CAPTEUR DE CHAMP MAGNÉTIQUE ET CAPTEUR FABRIQUÉ SELON LEDIT PROCÉDÉ

(30) Priorität: 04.12.2007 DE 102007058244; 15.09.2008 DE 102008042091
(43) Veröffentlichungstag der Anmeldung: 25.08.2010
(73) Patentinhaber: Robert Bosch GmbH, 70442 Stuttgart (DE)
(72) Erfinder: STEINBRINK, Ronald, 99086 Erfurt (DE); SCHULZE, Steffen, 99817 Eisenach (DE); HEGAZI, Anwar, 99192 Frienstedt (DE); BUSSE, Leo-Alexander, 99817 Eisenach (DE); OTTO, Werner, 99837 Dankmarshausen (DE); RUPPERT, Joerg, 99831 Creuzburg (DE); WEISHAEUTEL, Frank, 99869 Wangenheim (DE)
(86) Internationale Anmeldenummer: PCT/EP2008/064462
(87) Internationale Veröffentlichungsnummer: WO 2009/071390

(56) Entgegenhaltungen:
- EP-A- 1 619 506
- WO-A-2005/085875
- DE-A1- 19 757 006
- JP-A- 2005 227 177
- US-A- 5 414 355
- US-A1- 2002 180 424
- US-A1- 2006 260 418

## Beschreibung

### Stand der Technik

Die Erfindung geht aus von einem Verfahren zur Herstellung eines Magnetfeldsensors, insbesondere eines Drehzahl-und/oder Drehrichtungssensors für die Raddrehung oder für den Triebstrang eines Kraftfahrzeuges, sowie von einem nach dem gattungsgemäßen Verfahren hergestellten Magnetfeldsensor, wie er beispielsweise aus der WO 2005/085875 A1 bekannt ist. Diese Druckschrift offenbart einen Bewegungssensor und ein Verfahren zur Herstellung eines im Wesentlichen gleichachsig mit seinem Anschlusskabel ausgerichteten Bewegungssensors. Derartige Sensoren mit einem axialen Kabelabgang können auf einer vollautomatischen Fertigungslinie hergestellt werden, wobei die Verarbeitungsposition der biegeschlaffen Anschlussleitung in allen Stationen der Fertigungslinie gestreckt ist und gleich bleibt. Wenn die Einbaubedingungen des Sensors einen abgewinkelten, insbesondere einen um 90° abgewinkelten Kabelabhang erfordern, muss dieser entweder getrennt in einem manuell bestückten Spritzgießwerkzeug hergestellt oder die Biegung nachträglich in einem speziellen Arbeitsgang erzeugt werden. Aus der JP 2005-227177 ist ein Sensor bekannt mit einer vom Sensor getrennten Kappe, über die unterschiedliche Abgangsgeometrien des Sensorkabels flexibel angepasst werden können. Die Kappe kann hierzu aus zwei Halbschalen bestehen, um das Kabel in einem bestimmten Abgangswinkel zu führen.

### Offenbarung der Erfindung

Das erfindungsgemäße Verfahren mit den Merkmalen des unabhängigen Anspruchs und ein entsprechend gestalteter Sensor haben den Vorteil, dass für die Herstellung von Sensoren mit axialem Kabelabgang bewährte Fertigungsverfahren und Fertigungseinrichtungen zur Herstellung von Sensoren mit abgewinkeltem Kabelabgang nur mit einer Montagestation kombiniert werden müssen, in welcher dann ebenfalls vollautomatisch das Anschlusskabel gebogen und in der abgewinkelten Position durch geeignete Mittel arretiert wird. Zur Arretierung ist zweckmäßiger Weise ein als Rast- und/oder Nietkontur ausgebildetes Positioniermittel vorgesehen. Die Rast- und/oder Nietkontur kann an das Anschlusskabel angespritzt und nach dem Biegen des Kabels in seine vorbestimmte Winkelstellung mit einem ebenfalls als Rast- und/oder Nietkontur an der Befestigungslasche ausgebildeten Positioniermittel verrastet oder vernietet werden. Eine Rast- oder Nietkontur baut relativ klein, so dass sich der Materialaufwand gegenüber dem Stand der Technik verringert. Zum Biegen des Kabels in die vorbestimmte Winkelstellung muss das Kabel nicht mehr aus dem Werkstückträger entnommen werden, da die Art der Verbindung eine sofortige Arretierung ermöglicht. Dadurch verringern sich die Prozesszeiten. Unabhängig von der gewünschten Winkelstellung (radial oder axial) des Kabels relativ zum Sensor erlaubt dieses Konzept den Rückgriff auf nur eine einzige Fertigungslinie.

Besonders vorteilhaft ist es hierbei, wenn die Positioniermittel für das Anschlusskabel zumindest teilweise direkt an das Anschlusskabel und/oder an die elektrische Baugruppe des Sensors und/oder an dessen Befestigungslasche angespritzt werden, so dass lose Positionier- und Befestigungsmittel zumindest weitgehend entfallen und der gesamte Fertigungsprozess einschließlich der Anbringung der Positioniermittel für das Anschlusskabel vollautomatisch ausgeführt werden kann. Vorzugsweise werden die Positioniermittel an das Anschlusskabel und an die Befestigungslasche des Sensors angespritzt. Diese ist ihrerseits fest mit der elektrischen Baugruppe verbunden, welche das zu überwachende Magnetfeld erfasst und die Sensorsignale auswertet und demzufolge die Ausrichtung des Sensors und die Führung des Anschlusskabels bestimmt.

Eine zweckmäßige Ausgestaltung der Erfindung besteht dann darin, dass die Positioniermittel bei der Spritzgießumhüllung des Sensors teilweise direkt an die Befestigungslasche und an das Anschlusskabel angespritzt und teilweise lose nachträglich auf das gebogene Kabel aufgebracht werden. Hierdurch erreicht man, dass einerseits die in dem Spritzgießvorgang herzustellende Geometrie insgesamt relativ einfach gestaltet werden kann und andererseits die Winkelstellung des abgehenden Kabels durch die Auswahl unterschiedlicher loser Positioniermittel weitgehend frei wählbar ist. Hinsichtlich einer optimalen Rationalisierung des Fertigungsablaufes ist es jedoch sehr vorteilhaft, wenn alle Positioniermittel direkt beim Spritzgießen an das Anschlusskabel und/oder an die elektrische Baugruppe und/oder an die Befestigungslasche angeformt werden, weil so die Zahl der Arbeitsschritte reduziert wird. Dieses Verfahren ist insbesondere dann vorteilhaft, wenn nur eine bestimmte Winkelstellung für den Abgang des Kabels benötigt wird. Dies gilt vorzugsweise für einen rechtwinkligen Abgang des Anschlusskabels gegenüber der Ausrichtung der elektrischen Baugruppe, welcher sehr häufig realisiert wird.

In einer zweckmäßigen Weiterbildung wird die Verbindung durch Nieten, vorzugsweise Kaltnieten gebildet. Der hierfür vorgesehene Nietstempel beschreibt vorzugsweise eine Rosettenbahn (Hyperzykloide). Durch die Überlagerung translatorischer und kreiselnder Bewegungen kann eine Kraftreduzierung erzielt werden. Außerdem fließt das Material vorwiegend in radialer Richtung, was sich positiv auf Oberflächenstruktur und Wechselfestigkeit der Nietverbindung niederschlägt aufgrund geringer Gleitreibung und Torsionsspannungen.

In einer zweckmäßigen Weiterbildung ist eine Kappe vorgesehen, die am Kabelabgang vorgesehen ist. Hierdurch lässt sich in einfacher Weise ein Temperaturschutz für das Kabel erzielen, insbesondere bei ansonsten hohen Temperaturen ausgesetzten Bereichen.

Weitere Einzelheiten und vorteilhafte Ausgestaltungen der Erfindung ergeben sich aus den Unteransprüchen und der Beschreibung der Ausführungsbeispiele.

### Kurze Beschreibung der Zeichnungen

Ausführungsbeispiele der Erfindung sind in den Zeichnungen dargestellt und in der nachfolgenden Beschreibung näher erläutert.

Es zeigen:
- Figur 1: eine perspektivische Darstellung eines Magnetfeldsensors mit teilweise angespritzten Positioniermitteln vor dem Biegen des Kabelabgangs in eine abgewinkelte Position,
- Figur 2: eine perspektivische Darstellung eines Magnetfeldsensors mit rechtwinklig abgebogenem Anschlusskabel vor dem Aufstecken eines losen, kappenförmigen Positioniermittels,
- Figur 3: eine Darstellung des Magnetfeldsensors gemäß Figur 2 nach dem Aufstecken des kappenförmigen Positioniermittels,
- Figur 4: eine perspektivische Darstellung eines Magnetfeldsensors mit ausschließlich angespritzten Positioniermitteln vor dem Biegen des Kabels,
- Figur 5: einen Magnetfeldsensor entsprechend Figur 4 nach dem Biegen des Anschlusskabels in die vorgegebene Abgangsrichtung und der Verrastung der angespritzten Positioniermittel,
- Figuren 6a und 6b: Ansichten des Kabelabgangs eines Magnetfeldsensors in Richtung des Pfeils VI in Figur 5, wobei Figur 6a die verrasteten Positioniermittel vor dem Vernieten und Figur 6b die verrasteten Positioniermittel nach dem Vernieten zeigt,
- Figur 7: eine perspektivische Darstellung des fertigen Kabelabgangs eines Magnetfeldsensors entsprechend den Figuren 5 und 6b, und
- Figuren 8a bis 8c: perspektivische Ansichten eines Sensors nach einem weiteren Ausführungsbeispiel, wobei Figur 8a die Positioniermittel vor dem Vernieten, Figur 8b die Positioniermittel während des Biegens in die vernietete Position nach Figur 8c darstellen.

### Ausführungsformen der Erfindung

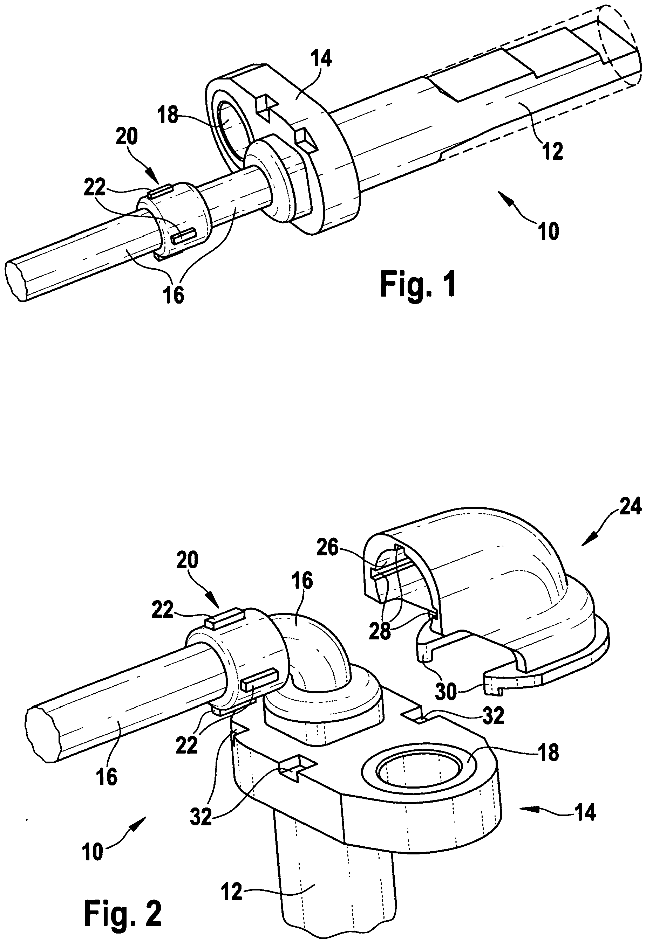

In der Figur 1 ist ein Magnetfeldsensor 10 dargestellt mit einer elektrischen Baugruppe 12 zur Erfassung und Auswertung von Magnetfeldsignalen, einer Befestigungslasche 14 und einem Anschlusskabel 16, welche gemeinsam in einem Spritzgießprozess mit Kunststoff umhüllt wurden und noch gerade ausgerichtet sind. Die gestrichelt dargestellte Außenkontur der elektrischen Baugruppe 12 ist zylinderförmig gestaltet und geht einteilig über in die ovale Befestigungslasche 14, welche seitlich des Kabelabgangs eine Befestigungsbuchse 18 aufweist. Auf das Anschlusskabel 16 ist nahe der Befestigungslasche 14 eine hülsenartige Kontur 20 mit Führungsrippen 22 aufgespritzt. Als Kunststoff für die einheitliche Spritzgießummantelung im Bereich der elektrischen Baugruppe 12, der Befestigungslasche 14 und des Anschlusskabels 16 eignet sich insbesondere ein Polyamidwerkstoff, in den auch die Befestigungsbuchse 18 der Befestigungslasche 14 eingebettet ist.

Die Arbeitsweise des Magnetfeldsensors 10 ist grundsätzlich bekannt und beispielsweise in der eingangs zum Stand der Technik genannten Druckschrift WO 2005/985875 beschrieben. Die Anwendungsmöglichkeiten des dargestellten Sensors sind sehr vielseitig. In Kraftfahrzeugen dient er insbesondere zur Bestimmung der Drehgeschwindigkeit, der Beschleunigung, des Beschleunigungsgradienten und/oder des Verdrehwinkels von rotierenden Teilen. Die Verwendung in Kraftfahrzeugen wird dabei begünstigt durch die einteilige Umspritzung der gesamten Anordnung einschließlich des Anschlusskabels, wodurch der Sensor vorzüglich auch in stark korrosionsgefährdeten Bereichen einsetzbar ist.

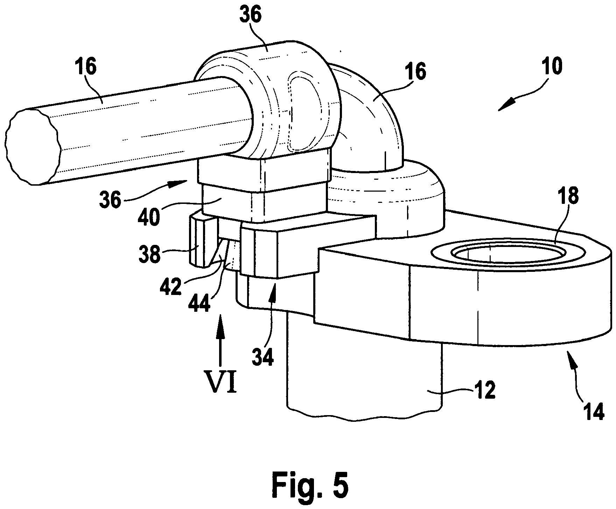

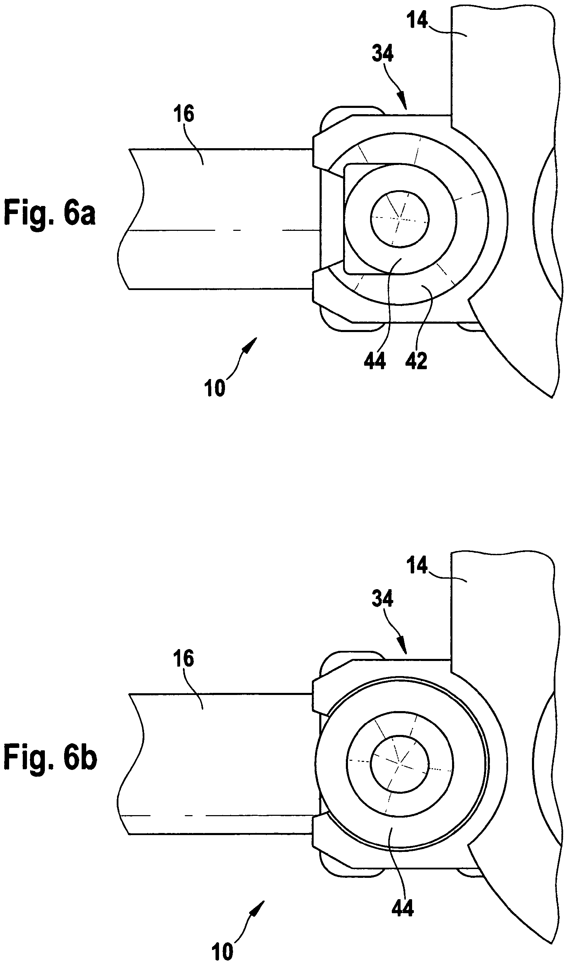

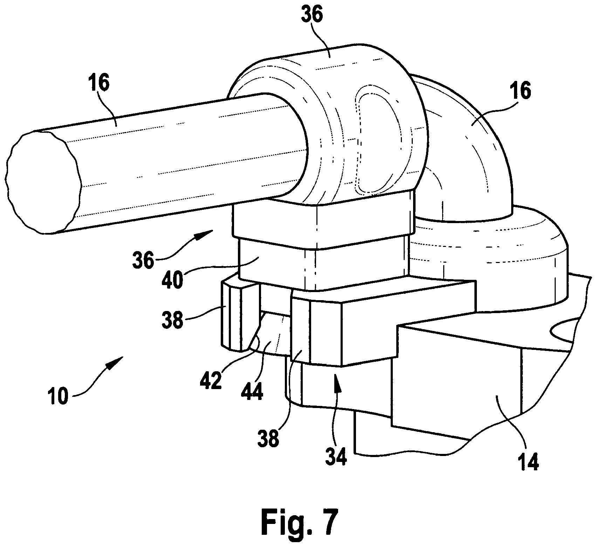

In den folgenden Figuren 2 bis 8 sind gleiche Teile der Sensoranordnung mit gleichen Bezugszeichen wie in Figur 1 versehen. Hierbei zeigt die Darstellung in Figur 2 den Magnetfeldsensor 10 mit rechtwinklig zur elektrischen Baugruppe 12 nahe der Befestigungslasche 14 abgebogenem Anschlusskabel 16, welches in dieser Position durch eine Kappe 24 arretiert wird. Hierzu weist die Kappe 24 einerseits eine der Biegung des Kabels entsprechende Aussparung 26 auf, mit der sie den gebogenen Teil des Kabels 16 umgreift. Zusätzlich sind in der Aussparung 26 Führungsnuten 28 ausgebildet, welche zusammen mit den Führungsrippen 22 auf der hülsenartigen Kontur 20 des Kabels 16 eine verdrehsichere Positionierung des Kabels gegenüber der Kappe 24 gewährleisten.

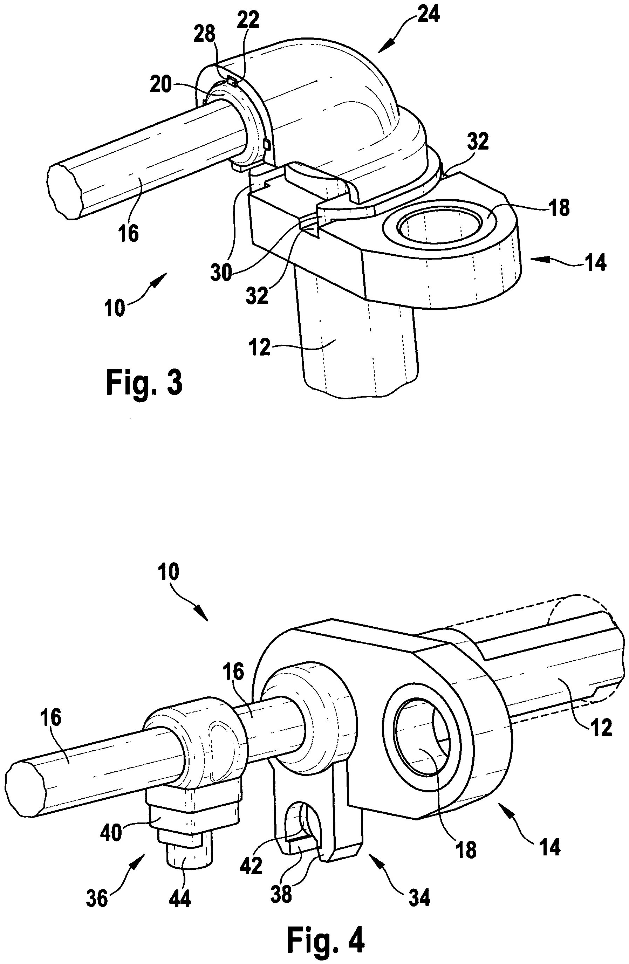

Die weitere Arretierung der Kappe 24 wird durch Vorsprünge 30 erreicht, welche rastend in Vertiefungen 32 an der Befestigungslasche 14 eingreifen und gemeinsam mit dem Führungsrippen 22 und den Führungsnuten 28 die Positionierung und Arretierung der Kappe 24 sichern. Diese Position der Kappe 24 ist in Figur 3 dargestellt. Alle Positionierungsmittel an der Befestigungslasche 14 und dem Kabel 16 sind in einem Arbeitsgang beim Umspritzen der Sensorbauteile angeformt. Die Gestaltung der Aussparung 26 in der Kappe 24 ist im dargestellten Ausführungsbeispiel so gewählt, dass eine rechtwinklige Umlenkung des Kabels 16 gegenüber der elektrischen Baugruppe 12 erfolgt. Bei Bedarf können auch beliebige andere Umlenkwinkel für das Kabel durch entsprechende Gestaltung der Kappe 24 realisiert werden.

Die Figuren 4 bis 8 zeigen eine weitere Ausführungsform des erfindungsgemäßen Verfahrens und des entsprechend ausgestalteten Magnetfeldsensors, wobei ausschließlich fest an das Anschlusskabel 16 und die Befestigungslasche 14 in einem Arbeitsgang mit der Umspritzung des Sensors angeformte Positioniermittel verwendet werden. Auch in dieser Ausführung sind die Positioniermittel am Anschlusskabel 16 nahe der Befestigungslasche 14 angebracht, so dass die korrespondieren Positioniermittel nach dem Biegen des Anschlusskabels leicht zusammengefügt werden können. Als Positioniermittel sind hierbei Rast- und Nietkonturen verwendet, wobei als negative Kontur ein doppelarmiger Ansatz 34 an der Befestigungslasche 14 und als positive Kontur eine zweistufige Anspritzung 36 am Anschlusskabel 16 dienen. Der Ansatz 34 an der Befestigungslasche 14 ist ebenfalls zweistufig gestaltet, und zwar einerseits mit Rastvorsprüngen 38, welche einen ersten Abschnitt 40 der Anspritzung 36 formschlüssig umgreifen und andererseits mit einem konischen Abschnitt 42, welcher die Arretierung für einen Nietabschnitt 44 an der Anspritzung 36 des Kabels 16 bildet.

Um ein Lösen der verschiedenen Positionierungs- und Arretierungsmittel mit Sicherheit auszuschließen ist zusätzlich vorgesehen, dass die jeweils korrespondierenden Teile nach dem Fügen durch Laserschweißen noch zusätzlich gesichert werden. Dies gilt sowohl für die aufgesteckte und verrastete Kappe 24 entsprechend der Ausführung in den Figuren 1 bis 3 wie auch für die verrasteten und vernieteten Teile in den Figuren 4 bis 8. Anstelle des Verschweißens dieser Teile wäre auch ein Verkleben als zusätzliche Sicherung möglich.

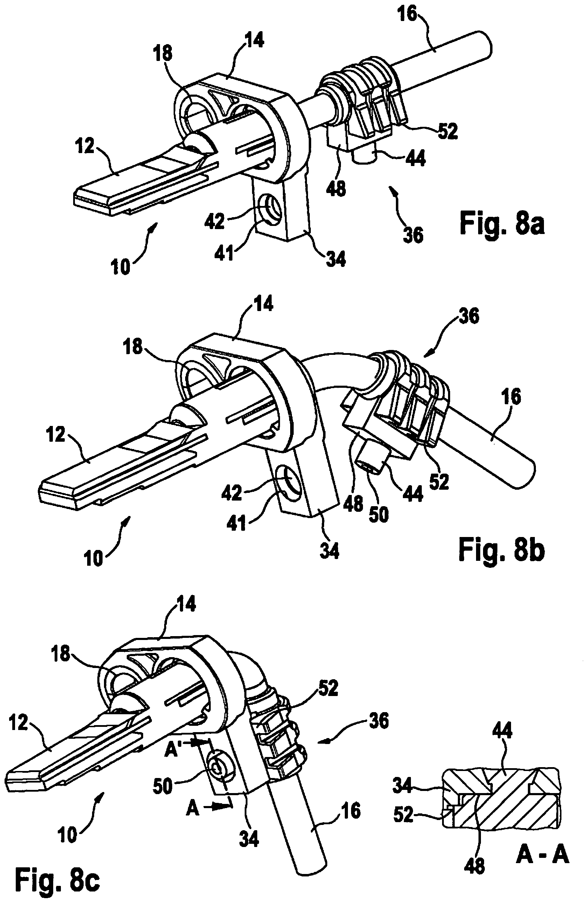

Das Ausführungsbeispiel nach den Figuren 8a bis 8c zeichnet sich gegenüber den vorherigen Ausführungsbeispielen dadurch aus, dass der Ansatz 34 im Wesentlichen rechteckförmig ausgeführt ist mit einer ungefähr mittig angeordneten Öffnung 41 zur Aufnahme des Nietabschnitts 44. Die auf dem Anschlusskabel 16 vorgesehene Anspritzung 36 weist einen im Wesentlichen rechteckförmigen Grundkörper 48 auf, auf dessen vom Anschlusskabel 16 wegweisenden Seite der Nietabschnitt 44 übersteht. Seitlich vom Grundkörper 48 bilden sich parallel zur Oberseite des Grundkörpers 48 orientierte, jedoch etwas in Richtung zum Anschlusskabel 16 zurückversetzte Anschlagsflächen 52 aus. Diese Anschlagsflächen 52 sind rippenförmig ausgebildet und wirken im montierten Zustand mit der Rückseite des Ansatzes 34 zusammen. Dieser Ansatz 34 weist eine nicht eigens bezeichnete Ausnehmung auf, die der Aufnahme des Grundkörpers 48 bis zu den Anschlagsflächen 52 hin dient. Die Öffnung 41 weist im oberen Bereich einen konischen Abschnitt 42 auf. Der Nietabschnitt 44 weist an seiner Oberseite eine zylinderförmige Ausnehmung 50 auf zur Aufnahme eines nicht gezeigten Nietstempels. Zur Erstellung radialer Kabelabgänge wird der Sensor 10 an der Anspritzung 36 gehalten und der Sensorkopf in Richtung zum Nietabschnitt 44 bewegt. Anschließend wird die Öffnung 41 im Ansatz 34 in den Nietabschnitt 44 eingesteckt. Danach wird der Sensor 10 an eine nicht gezeigte Nietstation übergeben. Dort wird mittels Kaltvernieten der Nietkopf des Nietabschnitts in der Öffnung 41 in eine konische Form gebracht zur formschlüssigen Verbindung der Anspritzung 36 mit dem Ansatz 34 wie in dem Schnitt gemäß Figur 8c entlang der Linie A'-A gezeigt. Zum Erstellen der Nietverbindung beschreibt der Nietstempel vorzugsweise eine Rosettenbahn (Hyperzykloide). Aufgrund der Überlagerung von translatorischer und kreiselnder Bewegung kann eine Kraftreduzierung erfolgen. Das Material des Nietabschnitts 44 fließt beim Vernieten vorwiegend in radialer Richtung. Die gewählte bevorzugte Rosettenbahn führt zu keiner bzw. nur geringer Relativbewegung zwischen Nietstempel und Material des Nietabschnitts 44. Dadurch erhöhen sich die Standzeiten. Aufgrund der sehr geringen Gleitreibung und Torsionsspannung weist die Verbindung eine ausgezeichnete Oberflächenstruktur und Wechselfestigkeit auf. Die Kappe 24 dient insbesondere als Temperaturschutz für das Anschlusskabel 16. Die Kappe 24 wird über die entsprechenden Befestigungsmittel mit dem Sensor 10 bzw. der Befestigungslasche 14 befestigt.

Insgesamt gewährleisten die vorgeschlagenen Maßnahmen eine exakte und dauerhafte Positionierung der Bauteile eines Magnetfeldsensors 10 mit radialem Kabelabgang sowie einen hohen Ausnutzungsgrad der eingesetzten Fertigungseinrichtungen bei vollautomatisierbarer Fertigung sowie eine gute Auslastung der Spritzgießwerkzeuge, da manuelle Bestückungsmaßnahmen der Werkzeuge weitestgehend entfallen. Außerdem kann die Variantenvielfalt in der Fertigung und damit der Fertigungsaufwand für unterschiedliche Sensoren deutlich reduziert werden, wobei herkömmliche Fertigungseinrichtungen für die Herstellung von Sensoren mit axialem und mit radialem oder schrägem Kabeleingang genutzt werden können und lediglich durch zusätzliche Montageeinrichtungen ergänzt werden müssen. Außerdem wird die Gefahr der Beschädigung der elektrischen Baugruppe des Sensors durch den erfindungsgemäßen Fertigungsablauf deutlich verringert, da für die Herstellung der Kabelbiegung kein zusätzlicher Energieeintrag in der Fertigung erforderlich ist.

## Patentansprüche

1. Verfahren zur Herstellung eines Magnetfeldsensors (10), insbesondere eines Drehzahl- und/oder Drehrichtungssensors für die Raddrehung oder für den Triebstrang eines Kraftfahrzeugs, wobei eine elektrische Baugruppe (12) und ein Anschlusskabel (16) durch Spritzgießen mit Kunststoff umhüllt und eine Befestigungslasche (14) angespritzt wird, wobei das Anschlusskabel (16) nach dem Spritzgießvorgang in eine Winkelstellung zu der elektrischen Baugruppe (12) und/oder der Befestigungslasche (14) gebogen und in dieser Stellung durch Positioniermittel arretiert wird, wobei als Positioniermittel Rast- und/oder Nietkonturen (34, 36; 38, 44; 41, 44) an das Anschlusskabel (16) und /oder an die Befestigungslasche (14) angespritzt werden , **dadurch gekennzeichnet, dass** ein an das Anschlusskabel (16) angespritzter Nietabschnitt (44) durch Radialnietung in einem konischen Abschnitt (42) eines an die Befestigungslasche (14) angespritzten Ansatzes (34) vernietet wird.

2. Verfahren nach Anspruch 1, **dadurch gekennzeichnet, dass** die Positioniermittel zumindest teilweise an das Anschlusskabel (16) und/oder an die elektrische Baugruppe (12) und/oder an die Befestigungslasche (14) angespritzt werden.

3. Verfahren nach Anspruch 1 oder 2, **dadurch gekennzeichnet, dass** Positioniermittel im gleichen Arbeitsgang mit dem Umspritzen der elektrischen Baugruppe (12) und/oder der Befestigungslasche (14) und/oder des Anschlusskabels (16) angespritzt werden.

4. Verfahren nach einem der vorhergehenden Ansprüche, **dadurch gekennzeichnet, dass** Positioniermittel an das Anschlusskabel (16) und an die Befestigungslasche (14) angespritzt werden.

5. Verfahren nach einem der vorhergehenden Ansprüche, **dadurch gekennzeichnet, dass** die Biegung und Arretierung des Anschlusskabels (16) unmittelbar neben der Befestigungslasche (14) erfolgt.

6. Verfahren nach einem der vorhergehenden Ansprüche, **dadurch gekennzeichnet, dass** die Positioniermittel teilweise an die Befestigungslasche (14) und an das Anschlusskabel (16) angespritzt werden und teilweise als loses Positioniermittel (24) nachträglich auf das gebogene Kabel (16) aufgebracht werden.

7. Verfahren nach Anspruch 6, **dadurch gekennzeichnet, dass** als loses Positioniermittel eine Kappe (24) mit einer den Biegungswinkel vorgegebenen Aussparung (26) auf das Kabel (16) aufgesteckt wird.

8. Verfahren nach Anspruch 6 oder 7, **dadurch gekennzeichnet, dass** das lose Positioniermittel (24) mittels angespritzter Konturen am Kabel (16) und/oder an der Befestigungslasche (14) arretiert werden.

9. Verfahren nach einem der Ansprüche 1 bis 5, **dadurch gekennzeichnet, dass** alle Positioniermittel durch Spritzgießen an das Anschlusskabel (16) und/oder die Befestigungslasche (14) und/oder die elektrische Baugruppe (12) angeformt werden.

10. Verfahren nach einem der vorhergehenden Ansprüche, **dadurch gekennzeichnet, dass** ein als Rast- und Nietkontur (49, 44) ausgebildetes Positioniermittel an das Anschlusskabel (16) angespritzt und nach dem Biegen des Kabels in seine vorbestimmte Winkelstellung mit einem ebenfalls als Rast-und Nietkontur (38, 42) an der Befestigungslasche (14) ausgebildeten Positioniermittel verrastet und zusätzlich vernietet wird.

11. Verfahren nach einem der vorhergehenden Ansprüche, **dadurch gekennzeichnet, dass** zur Bildung einer Vernietung ein Nietstempel in Form einer Rosettenbahn auf den Nietabschnitt (44) einwirkt.

12. Verfahren nach einem der vorhergehenden Ansprüche, **dadurch gekennzeichnet, dass** das Anschlusskabel (16) etwa rechtwinklig zu der Ausrichtung der elektrischen Baugruppe (12) des Sensors (10) gebogen und arretiert wird.

13. Sensor, insbesondere Drehzahl- und/oder Drehrichtungssensor für die Raddrehung oder für den Triebstrang eines Kraftfahrzeuges, mit einer elektrischen Baugruppe (12), einem Anschlusskabel (16) und einer Befestigungslasche (14), mit Positioniermittel (34, 36; 38, 44; 41, 44) zum Arretieren des in eine Winkelstellung zu der elektrischen Baugruppe (12) und/oder der Befestigungslasche (14) gebogenen Anschlusskabels (16), wobei als Positioniermittel Rast- und/oder Nietkonturen (34, 36; 44; 41, 44) am Anschlusskabel (16) und/oder an der Befestigungslasche (14) vorgesehen sind, **dadurch gekennzeichnet, dass** ein an das Anschlusskabel (16) angespritzter Nietabschnitt (44) durch Radialnietung in einem konischen Abschnitt (42) eines an die Befestigungslasche (14) angespritzten Ansatzes (34) vernietet wird.

14. Sensor nach Anspruch 13, **dadurch gekennzeichnet, dass** Rast- und/oder Nietkonturen (34, 36; 38, 44; 41, 44) an einer Anspritzung (36) an dem Anschlusskabel (16) angeordnet sind.

15. Sensor nach einem der Ansprüche 13 oder 14, **dadurch gekennzeichnet**, das die Anspritzung (36) zumindest einen Nietabschnitt (44) aufweist, der mit zumindest einer Öffnung (41) an einem Ansatz (34) an der Befestigungslasche (14) zur Bildung einer Nietverbindung zusammenwirkt.

16. Sensor nach einem der Ansprüche 13 bis 15, **dadurch gekennzeichnet, dass** an der Anspritzung (36) zumindest eine Anschlagfläche (52) vorgesehen ist, die mit einem Ansatz (34) an der Befestigungslasche (14) zusammenwirkt zur Festlegung der Winkelstellung.

17. Sensor nach einem der Ansprüche 13 bis 16, **dadurch gekennzeichnet, dass** eine Kappe (24) mit einer den Biegungswinkel vorgegebenen Aussparung (26) auf das Kabel (16) vorgesehen ist.

## Claims

1. Method for producing a magnetic field sensor (10), in particular a rotational speed and/or rotational direction sensor for the turning of a wheel or for the drive train of a motor vehicle, wherein an electrical subassembly (12) and a connection cable (16) are encapsulated with plastic by injection moulding and a fastening lug (14) is moulded on, wherein the connection cable (16) is bent into an angular position in relation to the electrical subassembly (12) and/or the fastening lug (14) after the injection-moulding operation and arrested in this position by positioning means, with engaging and/or riveting contours (34, 36; 38, 44; 41, 44) being moulded onto the connection cable (16) and/or onto the fastening lug (14) as positioning means, **characterized in that** a riveting portion (44) moulded onto the connection cable (16) is riveted by radial riveting in a conical portion (42) of an extension (34) moulded onto the fastening lug (14).

2. Method according to Claim 1, **characterized in that** the positioning means are at least partly moulded onto the connection cable (16) and/or onto the electrical subassembly (12) and/or onto the fastening lug (14).

3. Method according to Claim 1 or 2, **characterized in that** positioning means are moulded on in the same operation as the encapsulation of the electrical subassembly (12) and/or the fastening lug (14) and/or the connection cable (16).

4. Method according to one of the preceding claims, **characterized in that** positioning means are moulded onto the connection cable (16) and onto the fastening lug (14).

5. Method according to one of the preceding claims, **characterized in that** the bending and arresting of the connection cable (16) is performed directly alongside the fastening lug (14).

6. Method according to one of the preceding claims, **characterized in that** the positioning means are partly moulded onto the fastening lug (14) and onto the connection cable (16) and are partly subsequently applied to the bent cable (16) as unattached positioning means (24).

7. Method according to Claim 6, **characterized in that**, as unattached positioning means, a cap (24) with a recess (26) predetermined by the bending angle is fitted onto the cable (16).

8. Method according to Claim 6 or 7, **characterized in that** the unattached positioning means (24) is arrested on the cable (16) and/or on the fastening lug (14) by means of moulded-on contours.

9. Method according to one of Claims 1 to 5, **characterized in that** all the positioning means are moulded onto the connection cable (16) and/or the fastening lug (14) and/or the electrical subassembly (12) by injection moulding.

10. Method according to one of the preceding claims, **characterized in that** a positioning means formed as an engaging and riveting contour (49, 44) is moulded onto the connection cable (16) and, after the bending of the cable into its predetermined angular position, is engaged and additionally riveted by a positioning means likewise formed as an engaging and riveting contour (38, 42) on the fastening lug (14).

11. Method according to one of the preceding claims, **characterized in that** a riveting punch in the form of a hypocycloid acts on the riveting portion (44) to form the riveted joint.

12. Method according to one of the preceding claims, **characterized in that** the connection cable (16) is bent and arrested approximately at right angles in relation to the alignment of the electrical subassembly (12) of the sensor (10).

13. Sensor, in particular a rotational speed and/or rotational direction sensor for the turning of a wheel or for the drive train of a motor vehicle, with an electrical subassembly (12), a connection cable (16) and a fastening lug (14), with positioning means (34, 36; 38, 44; 41, 44) for arresting the connection cable (16) bent into an angular position in relation to the electrical subassembly (12) and/or the fastening lug (14), with engaging and/or riveting contours (34, 36; 44; 41, 44) being provided on the connection cable (16) and/or on the fastening lug (14) as positioning means, **characterized in that** a riveting portion (44) moulded onto the connection cable (16) is riveted by radial riveting in a conical portion (42) of an extension (34) moulded onto the fastening lug (14).

14. Sensor according to Claim 13, **characterized in that** engaging and/or riveting contours (34, 36; 38, 44; 41, 44) are arranged on a moulded attachment (36) on the connection cable (16).

15. Sensor according to either of Claims 13 and 14, **characterized in that** the moulded attachment (36) has at least one riveting portion (44), which interacts with at least one opening (41) on an extension (34) on the fastening lug (14) to form a riveted connection.

16. Sensor according to one of Claims 13 to 15, **characterized in that** at least one stop face (52) is provided on the moulded attachment (36) and interacts with an extension (34) on the fastening lug (14) to fix the angular position.

17. Sensor according to one of Claims 13 to 16, **characterized in that** a cap (24) is provided with a recess (26), predetermined by the bending angle, towards the cable (16).

## Revendications

1. Procédé de fabrication d'un capteur de champ magnétique (10), en particulier d'un capteur de vitesse de rotation et/ou de sens de rotation pour la rotation des roues ou pour la chaîne cinématique d'un véhicule automobile, un module électrique (12) et un câble de raccordement (16) étant enrobés de plastique par moulage par injection et une patte de fixation (14) étant moulée par injection, le câble de raccordement (16) étant courbé selon une position angulaire par rapport au module électrique (12) et/ou à la patte de fixation (14) après l'opération de moulage par injection, et étant bloqué dans cette position au moyen de moyens de positionnement, des contours d'encliquetage et/ou de rivetage (34, 36 ; 38, 44 ; 41, 44) étant moulés par injection sur le câble de raccordement (16) et/ou sur la patte de fixation (14) en tant que moyens de positionnement, **caractérisé en ce qu'**une section de rivetage (44) moulée par injection sur le câble de raccordement (16) est rivetée par rivetage radial dans une section conique (42) d'une saillie (34) moulée par injection sur la patte de fixation (14).

2. Procédé selon la revendication 1, **caractérisé en ce que** les moyens de positionnement sont moulés par injection au moins en partie sur le câble de raccordement (16) et/ou sur le module électrique (12) et/ou sur la patte de fixation (14).

3. Procédé selon la revendication 1 ou 2, **caractérisé en ce que** des moyens de positionnement sont moulés par injection lors de la même étape de travail que le surmoulage du module électrique (12) et/ou de la patte de fixation (14) et/ou du câble de raccordement (16).

4. Procédé selon l'une quelconque des revendications précédentes, **caractérisé en ce que** des moyens de positionnement sont moulés par injection sur le câble de raccordement (16) et sur la patte de fixation (14).

5. Procédé selon l'une quelconque des revendications précédentes, **caractérisé en ce que** la courbure et le blocage du câble de raccordement (16) s'effectuent directement à côté de la patte de fixation (14).

6. Procédé selon l'une quelconque des revendications précédentes, **caractérisé en ce que** les moyens de positionnement sont moulés par injection en partie sur la patte de fixation (14) et sur le câble de raccordement (16), et sont appliqués ultérieurement sur le câble courbé (16) en partie en tant que moyen de positionnement (24) lâche.

7. Procédé selon la revendication 6, **caractérisé en ce qu'**un capuchon (24) doté d'un évidement (26) prédéfini par l'angle de courbure est emboîté sur le câble (16) en tant que moyen de positionnement lâche.

8. Procédé selon la revendication 6 ou 7, **caractérisé en ce que** le moyen de positionnement (24) lâche est bloqué sur le câble (16) et/ou sur la patte de fixation (34) au moyen de contours moulés par injection.

9. Procédé selon l'une quelconque des revendications 1 à 5, **caractérisé en ce que** tous les moyens de positionnement sont formés par moulage par injection sur le câble de raccordement (16) et/ou la patte de fixation (14) et/ou le module électrique (12).

10. Procédé selon l'une quelconque des revendications précédentes, **caractérisé en ce qu'**un moyen de positionnement réalisé en tant que contour d'encliquetage et de rivetage (49, 44) est moulé par injection sur le câble de raccordement (16), et après la courbure du câble dans sa position angulaire prédéterminée, est encliqueté et en outre riveté au moyen d'un moyen de positionnement réalisé également en tant que contour d'encliquetage et de rivetage (38, 42) sur la patte de fixation (14).

11. Procédé selon l'une quelconque des revendications précédentes, **caractérisé en ce qu'**une bouterolle agit sur la section de rivetage (44) sous la forme d'une trajectoire en rosette en vue de la formation d'un rivetage.

12. Procédé selon l'une quelconque des revendications précédentes, **caractérisé en ce que** le câble de raccordement (16) est courbé et bloqué approximativement perpendiculairement à l'orientation du module électrique (12) du capteur (10).

13. Capteur, en particulier capteur de vitesse de rotation et/ou de sens de rotation pour la rotation des roues ou pour la chaîne cinématique d'un véhicule automobile, comprenant un module électrique (12), un câble de raccordement (16) et une patte de fixation (14), comprenant des moyens de positionnement (34, 36 ; 38, 44 ; 41, 44) en vue du blocage du câble de raccordement (16) courbé selon une position angulaire par rapport au module électrique (12) et/ou à la patte de fixation (14), des contours d'encliquetage et/ou de rivetage (34, 36 ; 44 ; 41, 44) étant prévus sur le câble de raccordement (16) et/ou sur la patte de fixation (14) en tant que moyens de positionnement, **caractérisé en ce qu'**une section de rivetage (44) moulée par injection sur le câble de raccordement (16) est rivetée par rivetage radial dans une section conique (42) d'une saillie (34) moulée par injection sur la patte de fixation (14).

14. Capteur selon la revendication 13, **caractérisé en ce que** des contours d'encliquetage et/ou de rivetage (34, 36 ; 38, 44 ; 41, 44) sont disposés sur une pièce moulée par injection (36) sur le câble de raccordement (16).

15. Capteur selon la revendication 13 ou 14, **caractérisé en ce que** la pièce moulée par injection (36) comprend au moins une section de rivetage (44) qui coopère avec au moins une ouverture (41) sur une saillie (34) sur la patte de fixation (14) en vue de la formation d'une liaison par rivetage.

16. Capteur selon l'une quelconque des revendications 13 à 15, **caractérisé en ce qu'**au moins une surface de butée (52) est prévue sur la pièce moulée par injection (36), laquelle surface de butée coopère avec une saillie (34) sur la patte de fixation (14) en vue de la fixation de la position angulaire.

17. Capteur selon l'une quelconque des revendications 13 à 16, **caractérisé en ce qu'**un capuchon (24) doté d'un évidement (26) prédéfini par l'angle de courbure est prévu sur le câble (16).
